# EUROPEAN PATENT APPLICATION

(11) **EP 2 234 169 A1**
(43) Date of publication of application: **29.09.2010**
(21) Application number: 08865004.9
(22) Date of filing: 27.11.2008
(51) Int. Cl.: H01L 31/04

(54) **PHOTOELECTRIC CONVERSION DEVICE AND METHOD FOR MANUFACTURING PHOTOELECTRIC CONVERSION DEVICE**

(30) Priority: 25.12.2007 JP 2007332429
(71) Applicant: Sharp Kabushiki Kaisha, Osaka-shi Osaka 545-8522 (JP)
(72) Inventor: OZAKI, Ryo, Osaka-shi Osaka 545-8522 (JP); TZUNEMI, Akiko, Osaka-shi Osaka 545-8522 (JP); YAMAZAKI, Tsutomu, Osaka-shi Osaka 545-8522 (JP); OKAMOTO, Satoshi, Osaka-shi Osaka 545-8522 (JP)
(74) Representative: Müller - Hoffmann & Partner
(86) International application number: PCT/JP2008/071521
(87) International publication number: WO 2009/081684

(57) **Abstract**

Provided are a photoelectric conversion device (10) having a first conductivity type semiconductor (1), a first main surface (1a) of the first conductivity type semiconductor (1) being provided with a concave portion (26, 27) formed therein, the photoelectric conversion device (10) including: a second conductivity type semiconductor (3) formed in the first main surface (1a) of the first conductivity type semiconductor (1), an inner wall surface of a through-hole (19), and a second main surface (1c) of the first conductivity type semiconductor (1); a light-receiving surface electrode (5a, 5c) formed to fill the concave portion (26, 27) in the first main surface (1a) of the first conductivity type semiconductor (1); a first electrode (2) formed on the second main surface (1c) of the first conductivity type semiconductor (1); a through-hole electrode portion (9) formed inside the through-hole (19) to be in contact with the second conductivity type semiconductor (3) in the inner wall surface of the through-hole (19); and a second electrode (7) formed on the second conductivity type semiconductor (3) in the second main surface (1c) of the first conductivity type semiconductor (1) to be in contact with the through-hole electrode portion (9), the light-receiving surface electrode (5a, 5c) and the second electrode (7) being electrically connected by the through-hole electrode portion (9); and a method of manufacturing the photoelectric conversion device (10).

## Description

### TECHNICAL FIELD

The present invention relates to a photoelectric conversion device and a method of manufacturing a photoelectric conversion device, and in particular, to a photoelectric conversion device having excellent characteristics and capable of being manufactured simply and inexpensively, and a method of manufacturing the photoelectric conversion device.

### BACKGROUND ART

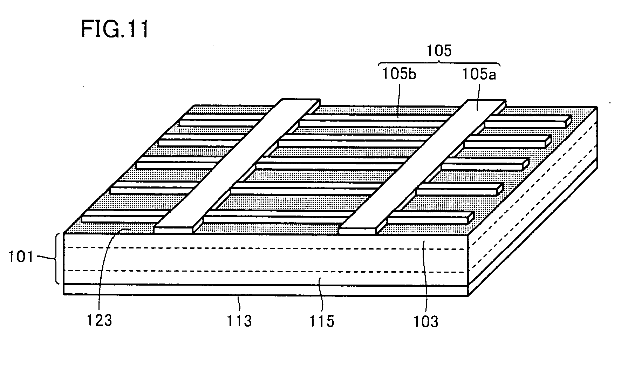

Fig. 11 shows a schematic perspective view of an exemplary conventional solar cell in which a pn junction is formed in a monocrystalline silicon substrate or a polycrystalline silicon substrate. The conventional solar cell has a configuration in which an n-type impurity diffused layer 103 is formed in a light-receiving surface of a p-type silicon substrate 101, and an anti-reflection film 123 is formed on n-type impurity diffused layer 103. Further, a grid-like light-receiving surface electrode 105 including main electrodes 105a and sub electrodes lost is formed on the light-receiving surface of p-type silicon substrate 101, and a highly-doped p-type impurity diffused layer 115 and a back surface electrode 113 in contact therewith are formed at a back surface of p-type silicon substrate 101 as a surface opposite to the light-receiving surface.

Here, as p-type silicon substrate 101, a silicon substrate produced by slicing a silicon ingot fabricated by the CZ (Czochralski) method or the cast method, using the multi-wire method, and then subjecting the entire light-receiving surface to chemical treatment to form fine irregularities (height: approximately 10 µm) in the light-receiving surface can be used. Further, n-type impurity diffused layer 103 can be formed, for example, by diffusing n-type impurities into the light-receiving surface of p-type silicon substrate 101 by the thermal diffusion method. Light-receiving surface electrode 105 is formed by printing a silver paste on the light-receiving surface of p-type silicon substrate 101, and then firing the silver paste. Highly-doped p-type impurity diffused layer 115 and back surface electrode 113 are formed by printing an aluminum paste on the back surface of p-type silicon substrate 101 and then firing the aluminum paste (see for example Japanese Patent Laying-Open No. 2002-176186 (Patent Document 1)).

Sub electrode 105b of light-receiving surface electrode 105 generally has a width of approximately 0.2 mm, and main electrode 105a of light-receiving surface electrode 105 generally has a width of approximately 2 mm. Light-receiving surface electrode 105 is designed such that as much sunlight as possible is incident on the light-receiving surface of p-type silicon substrate 101.

In the following, an operation principle in a case where sunlight is incident on a light-receiving surface of a solar cell will be briefly described. Sunlight applied to a portion of the light-receiving surface of p-type silicon substrate 101 in which light-receiving surface electrode 105 is present is reflected, causing a loss. On the other hand, in a portion of the light-receiving surface of p-type silicon substrate 101 in which light-receiving surface electrode 105 is not present, most of sunlight incident on the light-receiving surface of the solar cell enters p-type silicon substrate 101 due to the effects of anti-reflection film 123 and the irregularities formed in the light-receiving surface. The sunlight entering p-type silicon substrate 101 is absorbed in p-type silicon substrate 101 in accordance with an absorption coefficient of silicon. Then, the sunlight absorbed in p-type silicon substrate 101 excites electrons and holes as carriers to cause photoelectric conversion. As a result, current and voltage can be extracted from light-receiving surface electrode 105 and back surface electrode 113 that sandwich the pn junction.

Further, as another solar cell, a solar cell configured by forming a slit-like groove in a light-receiving surface of a silicon substrate by laser processing or the like, and embedding a metal in the groove by plating to form a light-receiving surface electrode has also been proposed (see for example Japanese Patent Laying-Open No. 8-191152 (Patent Document 2)). In the solar cell of Patent Document 2, the width of the light-receiving surface electrode is reduced to not more than approximately 0.05 mm, which is a fraction of a conventional width. Therefore, even in a case where a silicon substrate having a light-receiving surface with the same area is used, the area of the light-receiving surface of the silicon substrate on which sunlight is incident is increased, and thus a higher photoelectric conversion efficiency can be obtained. Further, in the solar cell of Patent Document 2, since the groove is designed to have a deep depth although the width of the light-receiving surface electrode (corresponding to the groove width) is set to not more than approximately 0.05 mm, the cross sectional area of the light-receiving surface electrode is ensured, preventing an increase in series resistance.

Furthermore, as another solar cell, a solar cell configured by forming a sub electrode of a light-receiving surface electrode by drawing the sub electrode a plurality of times using the nozzle drawing method has also been proposed (see for example Japanese Patent Laying-Open No. 2005-353691 (Patent Document 3)). In the solar cell of Patent Document 3, since the sub electrode in the vicinity of a main electrode can be formed to become thicker in steps, line resistance of the sub electrode can be decreased, and series resistance of the cell can be decreased. It is to be noted that, in the solar cell of Patent Document 3, the width of the sub electrode is set to approximately 0.12 mm.

In addition, as another solar cell, an MWT (Metallization Wrap Through) cell structure has been proposed (see for example "A SYSTEMATIC APPROACH TO REDUCE PROCESS-INDUCED SHUNTS IN BACK-CONTACTED MC-SI SOLAR CELLS" by Filip Granek, et al., IEEE 4th World Conference on Photovoltaic Energy Conversion, (U.S.), 2006, pp. 1319-1322 (Non-Patent Document 1)). The MWT cell structure has a configuration in which a portion of a light-receiving surface electrode is taken out to a back surface side via a through-hole formed in a silicon substrate. In the MWT cell structure, the area occupancy rate of the light-receiving surface electrode on a light-receiving surface of the silicon substrate can be reduced.
Patent Document 1 : Japanese Patent Laying-Open No. 2002-176186
Patent Document 2 : Japanese Patent Laying-Open No. 8-191152
Patent Document 3 : Japanese Patent Laying-Open No. 2005-353691
Non-Patent Document 1 : "A SYSTEMATIC APPROACH TO REDUCE PROCESS-INDUCED SHUNTS IN BACK-CONTACTED MC-SI SOLAR CELLS" by Filip Granek, et al., IEEE 4th World Conference on Photovoltaic Energy Conversion, (U.S.), 2006, pp. 1319-1322.

### DISCLOSURE OF THE INVENTION

### PROBLEMS TO BE SOLVED BY THE INVENTION

In a case where a light-receiving surface electrode is formed by printing a silver paste on a light-receiving surface of a silicon substrate as in Patent Document 1, it is necessary to prevent heat loss by limiting a resistance value of the light-receiving surface electrode in a sub electrode direction to not more than a certain value, in order to cause a current in an amount proportional to the area of the light-receiving surface to flow without loss. However, there is a limit in significantly reducing the width of the sub electrode, as a printable thickness of the silver paste is determined depending on the manufacturing method.

Therefore, in this case, it is difficult to achieve such as reduction of surface recombination of carriers in the vicinity of the light-receiving surface electrode on the light-receiving surface of the silicon substrate, posing a problem that photoelectric conversion efficiency cannot be fully increased. In addition, a stress occurs at an interface between the light-receiving surface electrode and the silicon substrate, due to a difference in thermal expansion coefficients of an electrode material and a substrate material. When the sub electrode has a wide width, the stress in the width direction is increased, and thus it is not possible to deal with reduction in thickness of the silicon substrate. Further, there is a problem such that other substrate materials having a low mechanical strength other than silicon cannot be used.

Further, in a method of forming a light-receiving surface electrode by embedding a metal in a groove formed in a light-receiving surface of a silicon substrate as in Patent Document 2, it is necessary to work the groove finely and deeply into the light-receiving surface of the silicon substrate. Therefore, in a case where a groove is formed in a light-receiving surface of a silicon substrate as in Patent Document 2, a method of applying a fine laser beam having high energy to the light-receiving surface of the silicon substrate to evaporate silicon, and high-precision working using a thin blade rotating at a high speed are required, leading to an increase in manufacturing cost. In addition, embedding of the metal in the slit-like groove cannot be performed by utilizing the low-cost printing method, and requires a troublesome and time-consuming electrode forming method such as wet plating. Accordingly, there has been a problem that it is industrially difficult to mass produce solar cells rapidly, with reduced manufacturing cost.

Furthermore, in a method of forming a sub electrode in the vicinity of a main electrode to become thicker in steps by the nozzle drawing method as in Patent Document 3, there are problems that nozzle drawing should be performed a plurality of times to cause the sub electrode to have a target height, and that a high positioning accuracy is required.

In addition, in a solar cell having an MWT cell structure as in Non-Patent Document 1, although it is possible to reduce the area occupancy rate of a light-receiving surface electrode on a light-receiving surface of a silicon substrate, in a case where the number of through-holes is increased without forming a main electrode, the length of pn junction isolation in a back surface of the silicon substrate is increased, and thus photoelectric conversion efficiency cannot be fully increased. In this case, the length of the pn junction isolation in the back surface of the silicon substrate can be reduced by forming a main electrode with an appropriate area that collects electrons collected from a plurality of sub electrodes on the light-receiving surface of the silicon substrate, and providing a through-hole in the main electrode to reduce the number of through-holes.

In this case, however, since the main electrode is formed on the light-receiving surface, it is difficult to achieve the original purpose of the MWT cell structure (i.e., to reduce the area occupancy rate of the light-receiving surface electrode and improve the amount of extractable current).

The present invention has been made in view of the above-mentioned problems, and one object of the present invention is to provide a photoelectric conversion device having excellent characteristics and capable of being manufactured simply and inexpensively, and a method of manufacturing the photoelectric conversion device.

### MEANS FOR SOLVING THE PROBLEMS

The present invention is a photoelectric conversion device having a first conductivity type semiconductor, and a through-hole penetrating between a first main surface and a second main surface of the first conductivity type semiconductor, the first main surface of the first conductivity type semiconductor being provided with a concave portion formed therein, the photoelectric conversion device including: a second conductivity type semiconductor formed in the first main surface of the first conductivity type semiconductor, an inner wall surface of the through-hole, and the second main surface of the first conductivity type semiconductor; a light-receiving surface electrode formed to fill the concave portion in the first main surface of the first conductivity type semiconductor; a first electrode formed on the second main surface of the first conductivity type semiconductor; a through-hole electrode portion formed inside the through-hole to be in contact with the second conductivity type semiconductor in the inner wall surface of the through-hole; and a second electrode formed on the second conductivity type semiconductor in the second main surface of the first conductivity type semiconductor to be in contact with the through-hole electrode portion, the light-receiving surface electrode and the second electrode being electrically connected by the through-hole electrode portion.

Further, the present invention is a method of manufacturing the photoelectric conversion device described above, including the steps of: providing a conductive paste to fill the concave portion; and forming at least a portion of the light-receiving surface electrode by firing the conductive paste provided to the concave portion.

### EFFECTS OF THE INVENTION

According to the present invention, a photoelectric conversion device having excellent characteristics and capable of being manufactured simply and inexpensively, and a method of manufacturing the photoelectric conversion device can be provided.

### BRIEF DESCRIPTION OF THE DRAWINGS

Fig. 1(a) is a schematic plan view of an exemplary light-receiving surface of a photoelectric conversion device of the present invention, and Fig. 1(b) is a schematic plan view of an exemplary back surface of the photoelectric conversion device shown in Fig. 1(a).
Fig. 2 is a schematic cross sectional view taken along II-II in Fig. 1(b).
Fig. 3 is a schematic cross sectional view taken along III-III in Fig. 1(b).
Fig. 4 is a schematic cross sectional view illustrating a portion of a manufacturing process in accordance with an exemplary method of manufacturing the photoelectric conversion device shown in Figs. 1 to 3.
Fig. 5 is a schematic cross sectional view illustrating a portion of the manufacturing process in accordance with the exemplary method of manufacturing the photoelectric conversion device shown in Figs. 1 to 3.
Fig. 6 is a schematic cross sectional view illustrating a portion of the manufacturing process in accordance with the exemplary method of manufacturing the photoelectric conversion device shown in Figs. 1 to 3.
Fig. 7 is a schematic cross sectional view illustrating a portion of the manufacturing process in accordance with the exemplary method of manufacturing the photoelectric conversion device shown in Figs. 1 to 3.
Fig. 8 is a schematic cross sectional view illustrating a portion of the manufacturing process in accordance with the exemplary method of manufacturing the photoelectric conversion device shown in Figs. 1 to 3.
Fig. 9 is a schematic cross sectional view illustrating a portion of the manufacturing process in accordance with the exemplary method of manufacturing the photoelectric conversion device shown in Figs. 1 to 3.
Fig. 10 is a schematic cross sectional view illustrating a portion of the manufacturing process in accordance with the exemplary method of manufacturing the photoelectric conversion device shown in Figs. 1 to 3.
Fig. 11 is a schematic perspective view of an exemplary conventional solar cell.

### DESCRIPTION OF THE REFERENCE SIGNS

1: p-type semiconductor, 1a: first main surface, 1b: inner wall surface, 1c: second main surface, 2: first electrode, 3: n-type semiconductor, 5a: first main electrode, 5b, 105b: sub electrode, 5c: second main electrode, 7: second electrode, 9: through-hole electrode portion, 10: photoelectric conversion device, 13, 113: back surface electrode, 15: highly-doped p-type layer, 19: through-hole, 21: pn junction isolation portion, 23, 123: anti-reflection film, 26: first concave portion, 27: second concave portion, 101: p-type silicon substrate, 103: n-type impurity diffused layer, 105a: main electrode, 105: light-receiving surface electrode, 115: highly-doped p-type impurity diffused layer.

### BEST MODES FOR CARRYING OUT THE INVENTION

Hereinafter, various embodiments of the present invention will be described with reference to the drawings. The contents described in the drawings and in the description below are merely illustrative, and the scope of the present invention is not limited to the contents described in the drawings and in the description below. Although a description will now be given of an exemplary case where a first conductivity type is p-type, the description below is basically also applicable to a case where a first conductivity type is n-type, by necessary interpretation such as taking "p-type" in the description as "n-type". Further, in the drawings of the present invention, identical or corresponding parts will be designated by the same reference numerals.

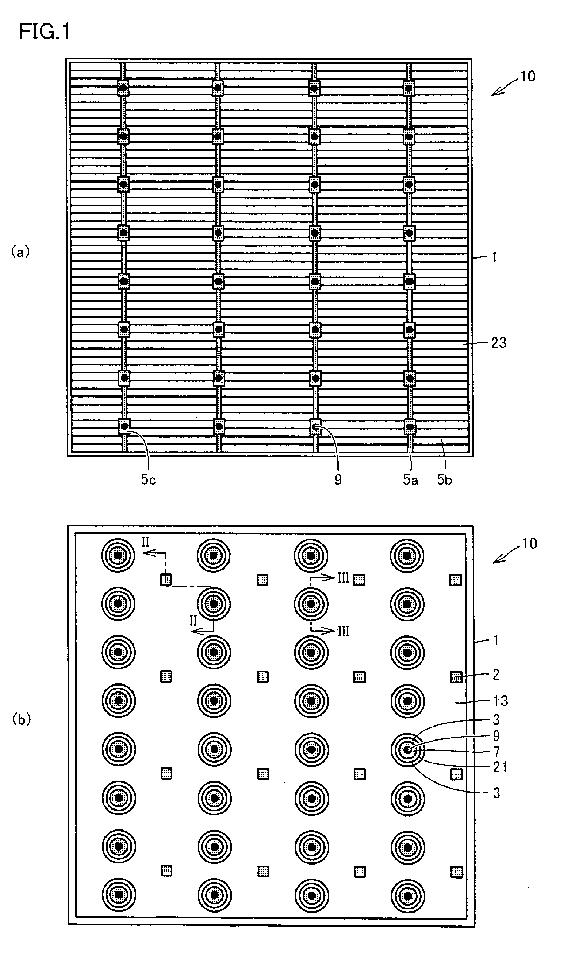

Fig. 1(a) shows a schematic plan view of an exemplary light-receiving surface of a photoelectric conversion device of the present invention, and Fig. 1(b) shows a schematic plan view of an exemplary back surface of the photoelectric conversion device shown in Fig. 1(a). As shown in Fig. 1(a), in a photoelectric conversion device 10, for example, a p-type silicon substrate is used as a p-type semiconductor 1. On a light-receiving surface of p-type semiconductor 1, a first main electrode 5a having a relatively thick line width, a second main electrode 5c having a line width thicker than that of the first main electrode 5a, and a sub electrode 5b having a relatively thin line width and formed to extend in a direction perpendicular to the first main electrode 5a and the second main electrode 5c are each formed as a light-receiving surface electrode. Further, a through-hole electrode portion 9 is embedded below the second main electrode 5c, and through-hole electrode portion 9 is formed to fill a through-hole penetrating p-type semiconductor 1 in its thickness direction from the light-receiving surface to a back surface of p-type semiconductor 1. Furthermore, an anti-reflection film 23 is formed on a first main surface 1a of p-type semiconductor 1, at a portion other than a portion where a light-receiving surface electrode 5 is formed.

In addition, as shown in Fig. 1(b), a back surface electrode 13 is formed almost all over the back surface of p-type semiconductor 1, and first electrodes 2 having a square surface are formed in a dotted manner on back surface electrode 13. Second electrodes 7 having a circular surface are formed in a dotted manner on a portion where back surface electrode 13 is not formed.

Further, a pn junction isolation portion 21 as a ring-shaped groove is formed to surround the outside of the second electrode 7. An n-type semiconductor 3 is located between the second electrode 7 and pn junction isolation portion 21, and between the second electrode 7 and back surface electrode 13.

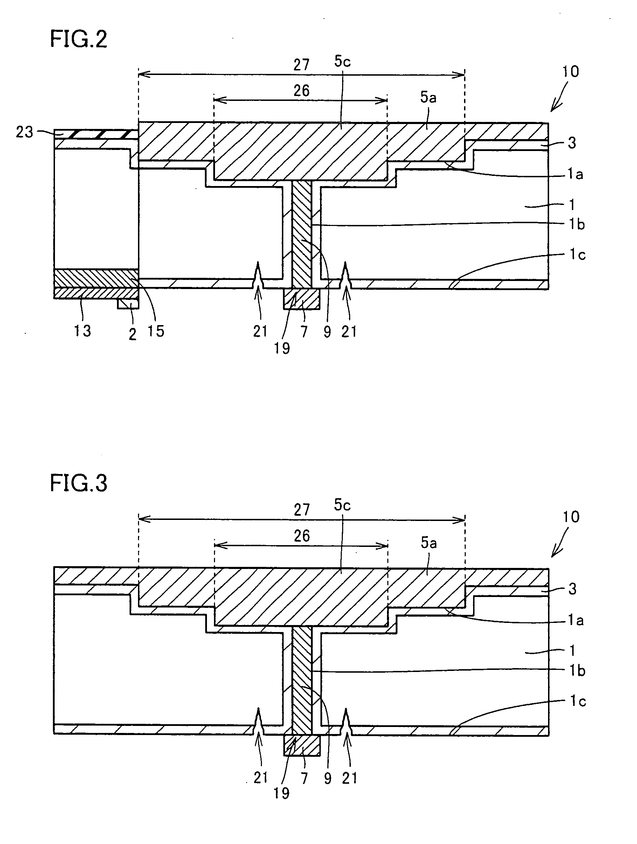

Fig. 2 shows a schematic cross sectional view taken along II-II in Fig. 1(b). Fig. 3 shows a schematic cross sectional view taken along III-III in Fig. 1(b). Here, in p-type semiconductor 1, a through-hole 19 penetrating from the first main surface 1a to a second main surface 1c of p-type semiconductor 1 is formed, and n-type semiconductor 3 is formed inside each of the first main surface 1a of p-type semiconductor 1, an inner wall surface 1b of through-hole 19, and the second main surface 1c of p-type semiconductor 1.

Further, a second concave portion 27 as a recess is formed in the first main surface 1a of p-type semiconductor 1, and a first concave portion 26 as a recess deeper than the second concave portion 27 is formed inside the second concave portion 27. The first main electrode 5a and the second main electrode 5c are formed to fill the first concave portion 26 and the second concave portion 27.

Inside through-hole 19, through-hole electrode portion 9 filling the inside of through-hole 19 to be in contact with inner wall surface 1b of through-hole 19 is formed. Through-hole electrode portion 9 and the second main electrode 5c are electrically connected by one end of through-hole electrode portion 9 being brought into contact with the second main electrode 5c, and through-hole electrode portion 9 and the second electrode 7 are electrically connected by the other end of through-hole electrode portion 9 being brought into contact with the second electrode 7. Therefore, the second main electrode 5c as the light-receiving surface electrode and the second electrode 7 are electrically connected via through-hole electrode portion 9.

Furthermore, the second electrode 7 is formed on n-type semiconductor 3 located in the second main surface 1c as a main surface of p-type semiconductor 1 opposite to the first main surface 1a, to be contact with n-type semiconductor 3, and pn junction isolation portion 21 as a ring-shaped groove is formed to surround the outer periphery of the second electrode 7. The groove constituting pn junction isolation portion 21 is deep enough to penetrate n-type semiconductor 3 to reach the inside of p-type semiconductor 1.

In addition, as shown in Fig. 2, a highly-doped p-type layer 15 in which p-type impurities are introduced into p-type semiconductor 1 is formed in the second main surface 1c of p-type semiconductor 1 (i. e., highly-doped p-type layer 15 has a p-type impurity concentration higher than that of p-type semiconductor 1), to be in contact with back surface electrode 13. A first electrode 2 is formed on a surface of back surface electrode 13 located opposite to highly-doped p-type layer 15.

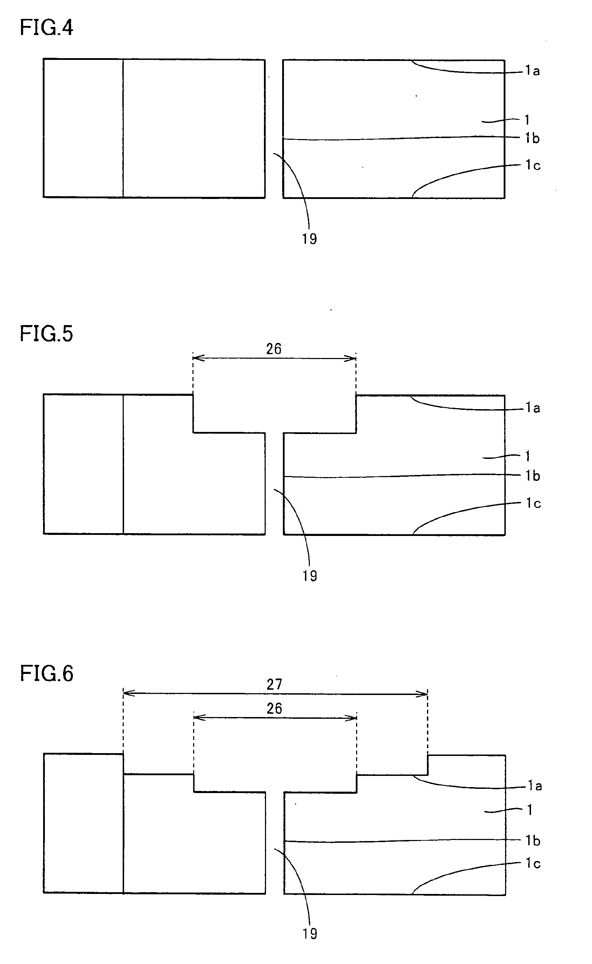

Hereinafter, an exemplary method of manufacturing photoelectric conversion device 10 shown in Figs. 1 to 3 will be described with reference to schematic cross sectional views in Figs. 4 to 10 each schematically showing a cross section taken along II-II in Fig. 1(b).

### (1) Step of forming the through-hole

Firstly, as shown in Fig. 4, through-hole 19 is formed in p-type semiconductor 1 made of a p-type silicon substrate or the like. Here, it is preferable that p-type semiconductor 1 is set to have a resistance value of, for example, approximately 0.1 to 20 Ωcm. The method of forming through-hole 19 is not particularly limited, and through-hole 19 can be formed, for example, by laser processing applying a laser beam, or the like. The shape and dimensions of through-hole 19 are also not particularly limited, and through-hole 19 can have an opening in the shape of, for example, a quadrangle (a square, a rectangle, or the like), or a circle.

### (2) Step of forming the concave portion

Next, as shown in Fig. 5, the first concave portion 26 is formed by partially removing a region outside of the opening of through-hole 19 in the first main surface 1a of p-type semiconductor 1, in the thickness direction of p-type semiconductor 1, to include the opening of through-hole 19. Here, the first concave portion 26 can be formed, for example, by applying a laser beam to the first main surface 1 a of p-type semiconductor 1 and removing a portion of p-type semiconductor 1, or the like.

Subsequently, as shown in Fig. 6, the second concave portion 27 is formed by partially removing a region outside of the first concave portion 26 in the first main surface 1a of p-type semiconductor 1, in the thickness direction of p-type semiconductor 1. Here, the second concave portion 27 can also be formed, for example, by applying a laser beam to the first main surface 1a of p-type semiconductor 1 and removing a portion of p-type semiconductor 1, or the like.

Thereafter, by etching the first main surface 1a of p-type semiconductor 1 using an acid or alkali solution or reactive plasma, a surface damaged layer resulting from the formation of through-hole 19, the first concave portion 26, and the second concave portion 27 may be removed, and a texture structure may be formed in the first main surface 1a of p-type semiconductor 1. As the texture structure, for example, an irregular surface structure with a difference in height of approximately 1 to 10 µm can be formed.

### (3) Step of forming the n-type semiconductor

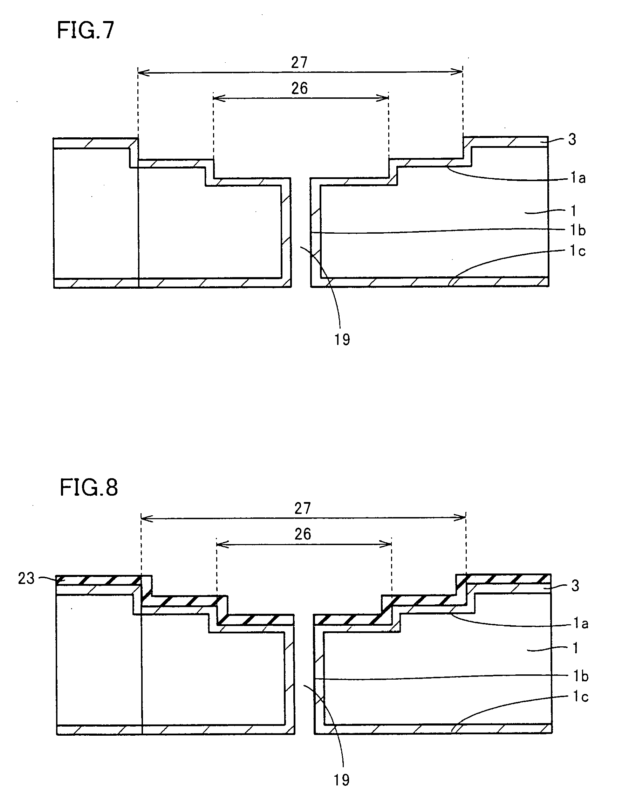

Next, as shown in Fig. 7, n-type semiconductor 3 is formed inside the surfaces of p-type semiconductor 1 (i.e., the first main surface 1a of p-type semiconductor 1, inner wall surface 1b of through-hole 19, the second main surface 1c of p-type semiconductor 1). Here, n-type semiconductor 3 can be formed, for example, by introducing n-type impurities into the surfaces of p-type semiconductor 1 (the first main surface 1a, inner wall surface 1b, and the second main surface 1c).

Introduction of n-type impurities can be performed, for example, by placing p-type semiconductor 1 in hot gas including a material (for example, POCl₃) containing n-type impurities. Thereby, n-type semiconductor 3 can be formed inside the respective surfaces of p-type semiconductor 1 (the first main surface 1a, inner wall surface 1b, and the second main surface 1c).

The method of forming n-type semiconductor 3 is not limited to the method described above, and may be formed, for example, by implanting ions of n-type impurities into the surfaces of p-type semiconductor 1. Further, instead of introducing n-type impurities into p-type semiconductor 1 to form n-type semiconductor 3, n-type semiconductor 3 may also be formed by separately growing a crystal of an n-type semiconductor layer on the surfaces of p-type semiconductor 1 by the CVD method or the like. In this case, a p-type semiconductor substrate such as a p-type silicon substrate entirely serves as p-type semiconductor 1.

The concentration of the n-type impurities in n-type semiconductor 3 is not particularly limited, and can be set to, for example, approximately 10¹⁸ to 10²¹/cm³.

### (4) Step of forming the anti-reflection film

Subsequently, as shown in Fig. 8, anti-reflection film 23 is formed on n-type semiconductor 3 in the first main surface 1 a of p-type semiconductor 1. Here, anti-reflection film 23 may be formed all over the first main surface 1a of p-type semiconductor 1, and can also be formed to have an opening in a region of the first main surface 1a of p-type semiconductor 1 in which the light-receiving surface electrode (the first main electrode 5a, sub electrode 5b, the second main electrode 5c) is to be formed.

In a case where anti-reflection film 23 is formed all over the first main surface 1a of p-type semiconductor 1, the light-receiving surface electrode (the first main electrode 5a, sub electrode 5b, the second main electrode 5c) is fired after being formed on anti-reflection film 23, and thereby conduction can be established between the light-receiving surface electrode and n-type semiconductor 3 in the first main surface 1a of p-type semiconductor 1 by firing through the light-receiving surface electrode.

The material for anti-reflection film 23, the thickness thereof, the method of manufacturing the same, and the like are not particularly limited as long as anti-reflection film 23 has a function of suppressing reflection of sunlight from the surface. Anti-reflection film 23 can be composed of, for example, a 70 nm-thick SiN film, and can be formed, for example, by the plasma CVD method.

### (5) Step of forming the back surface electrode and the highly-doped p-type layer

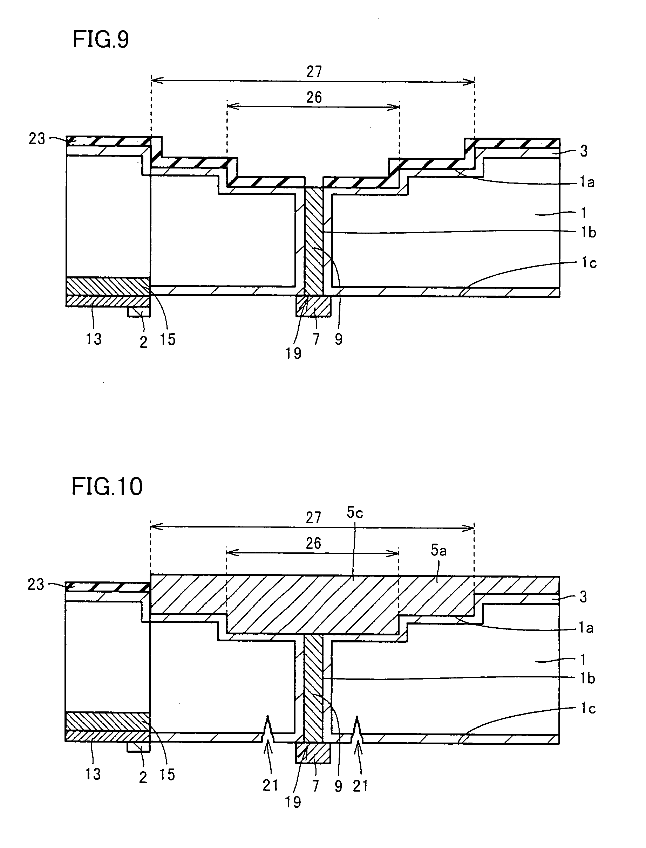

Next, as shown in Fig. 9, back surface electrode 13 is formed on the second main surface 1c of p-type semiconductor 1. Here, back surface electrode 13 can be formed, for example, by printing a paste containing aluminum onto the second main surface 1c of p-type semiconductor 1, and thereafter firing the paste. By firing the paste containing aluminum, aluminum is diffused immediately below back surface electrode 13, and thus highly-doped p-type layer 15 can be formed.

The depth of highly-doped p-type layer 15 can be adjusted as appropriate depending on the thickness of p-type semiconductor 1 and the like, and for example it is preferable that highly-doped p-type layer 15 has a depth of 0.2 to 6.0 µm from the second main surface 1c of p-type semiconductor 1.

Further, on the second main surface 1c of p-type semiconductor 1, a back surface electric field layer or a back surface reflection layer may be formed, or an oxide film, a nitride film, or the like may be formed to prevent surface recombination. As the back surface reflection layer and the anti-reflection film, an oxide film such as a silicon oxide film and a titanium oxide film, a nitride film, and the like can be used.

### (6) Step of forming the first electrode, the second electrode, and the through-hole electrode portion

Subsequently, as shown in Fig. 9, the first electrode 2 is formed on back surface electrode 13 on the second main surface 1c of p-type semiconductor 1, and through-hole electrode portion 9 is formed inside through-hole 19. Further, the second electrode 7 is formed to cover a portion of n-type semiconductor 3 in the second main surface 1c of p-type semiconductor 1 and the end of through-hole electrode portion 9. It is to be noted that the second electrode 7 can be formed such that pn junction isolation portion 21 is provided between the second electrode 7 and back surface electrode 13.

The materials for the first electrode 2, the second electrode 7, and through-hole electrode portion 9, the thicknesses thereof, the methods of manufacturing the same, and the like are not particularly limited as long as they can respectively serve as electrodes. The first electrode 2, the second electrode 7, and through-hole electrode portion 9 may be composed of an identical material, or at least one of them may be composed of a different material. Preferably, the first electrode 2, the second electrode 7, and through-hole electrode portion 9 are composed of a metal suitable for soldering, for example, silver.

The first electrode 2, the second electrode 7, and through-hole electrode portion 9 can also be formed, for example, by the deposition method, the printing-firing method, the plating method, or the like. For example, the second electrode 7 and through-hole electrode portion 9 can be simultaneously formed by a method such as printing a conductive paste, such as a paste containing a metal, from the second main surface 1c side of p-type semiconductor 1 and thereafter firing the conductive paste. It is preferable that the second electrode 7 and through-hole electrode portion 9 are also simultaneously formed, for example, by the deposition method or the plating method.

### (7) Step of forming the light-receiving surface electrode

Next, as shown in Fig. 10, the light-receiving surface electrode (the first main electrode 5a, sub electrode 5b, the second main electrode 5c) is formed on the first main surface 1a of p-type semiconductor 1. Here, the light-receiving surface electrode (the first main electrode 5a, sub electrode 5b, the second main electrode 5c) is not particularly limited as long as it is electrically connected to n-type semiconductor 3 in the first main surface 1a of p-type semiconductor 1, and can collect electric power generated in photoelectric conversion device 10 from n-type semiconductor 3.

The material for the light-receiving surface electrode is not particularly limited as long as the light-receiving surface electrode is formed of a conductive material. For example, the light-receiving surface electrode can be formed of a metal such as gold, platinum, silver, copper, aluminum, nickel, chromium, tungsten, iron, tantalum, titanium, or molybdenum, or an alloy thereof, a single layer or stacked layers of a transparent conductive material or the like such as SnO₂, In₂O₃, ZnO, or ITO, or a combination of a metal and an alloy described above.

The light-receiving surface electrode can be formed, for example, by mixing powder of a metal or an alloy described above into a resin to prepare a conductive paste, printing the conductive paste on the first main surface 1a of p-type semiconductor 1, and thereafter firing the conductive paste. The light-receiving surface electrode can also be formed, for example, by the deposition method or the like. In the case where the light-receiving surface electrode is formed by the deposition method, it is preferable to perform patterning by photolithography. The film thicknesses of these electrodes are not particularly limited, and can be set to, for example, approximately 1 to 50 µm.

The light-receiving surface electrode can be formed at any location, with any area. Preferably, the light-receiving surface electrode is formed to have an area of approximately 2 to 8% with respect to the entire area of the light-receiving surface of photoelectric conversion device 10, in the shape of stripes, a grid, islands, or the like.

### (8) Step of isolating pn junction

Subsequently, as shown in Fig. 10, pn junction isolation portion 21 is formed by forming a ring-shaped groove in the second main surface 1c of p-type semiconductor 1, and thus manufacture of photoelectric conversion device 10 is completed. Here, pn junction isolation portion 21 can be formed, for example, by applying a laser beam to the second main surface 1c of p-type semiconductor 1 and removing a portion of p-type semiconductor 1.

In photoelectric conversion device 10 of the present invention, after forming through-hole 19 in p-type semiconductor 1, the concave portion (the first concave portion 26 and the second concave portion 27) is formed, for example, using a laser beam or the like. Although the width and depth of the concave portion are not particularly limited, preferably, the width is, at most, substantially identical to the width of the main electrode, and the depth is approximately half the thickness of p-type semiconductor 1. Further, the concave portion may be formed to have a plurality of depths as described above, or may have one depth.

It is to be noted that the order of steps (1) to (8) described above can be changed as appropriate.

As has been described above, in photoelectric conversion device 10 of the present invention, the light-receiving surface electrode (the first main electrode 5a and the second main electrode 5c) is formed to be embedded in the concave portion (the first concave portion 26 and the second concave portion 27) in the first main surface 1a of p-type semiconductor 1 easily by a method such as printing, and thereby the light-receiving surface electrode (the first main electrode 5a and the second main electrode 5c) can be formed deeply (thickly).

Therefore, in photoelectric conversion device 10 of the present invention, the line width of the light-receiving surface electrode (the first main electrode 5a and the second main electrode 5c) can be reduced simply and inexpensively. Further, a wider cross sectional area of the light-receiving surface electrode (the first main electrode 5a and the second main electrode 5c) can also be ensured, when compared with a conventional light-receiving surface electrode having a reduce line width.

Consequently, photoelectric conversion device 10 of the present invention has excellent characteristics, and can be manufactured simply and inexpensively. Examples

### <Example 1>

Firstly, as shown in Fig. 4, laser beams were applied to p-type semiconductor 1 made of a p-type polycrystalline silicon substrate having an outer shape of 155 × 155 mm, a thickness of 0.20 mm, and a specific resistance of 2 Ωcm, to form a total of 32 through-holes 19 in 4 × 8 rows. The opening of through-hole 19 was in the shape of a circle, and had a diameter of approximately 0.30 mm.

Next, as shown in Figs. 5 and 6, with laser beam application conditions such as power and an application region being changed as appropriate, a laser beam was applied to the first main surface 1a of p-type semiconductor 1 and a portion thereof was removed to form the concave portion (the first concave portion 26 and the second concave portion 27) at a region around through-hole 19 in which the main electrodes (the first main electrode 5a and the second main electrode 5c) of the light-receiving surface electrode were to be formed.

Here, the first concave portion 26 was formed about the opening of through-hole 19 to have a length of 8 mm and a depth of approximately 0.05 mm, and the second concave portion 27 was formed to have a length 4 mm longer from each end of the first concave portion 26, and a depth of approximately 0.03 mm. The first concave portion 26 and the second concave portion 27 each had a width of 0.15 mm.

Subsequently, p-type semiconductor 1 was immersed in a solution at 80°C prepared by adding 7% alcohol to a 5% aqueous solution of sodium hydroxide for 10 minutes, to etch the surfaces of p-type semiconductor 1 by a depth of 20 µm. In this step, a fractured surface layer resulting from slicing of p-type semiconductor 1, and a fractured surface layer resulting from laser beam application at the time of forming through-hole 19, the first concave portion 26, and the second concave portion 27 were removed.

Then, p-type semiconductor 1 was inserted into a quartz tube in an electric furnace into which phosphorous oxychloride had been introduced, to cause phosphorus to diffuse at 830°C for 20 minutes. Thereby, as shown in Fig. 7, n-type semiconductor 3 with a depth of approximately 0.3 µm and a surface dopant concentration of approximately 10¹⁹/cm³ was formed. The sheet resistance value of n-type semiconductor 3 was approximately 70 Ω/□.

Next, a nitride silicon film with a film thickness of approximately 70 nm was formed as anti-reflection film 23 on the surface of n-type semiconductor 3 as shown in Fig. 8, by the plasma CVD method, using a plasma CVD apparatus, and using gaseous silane and ammonia.

Then, a paste containing aluminum powder was printed and dried on the second main surface 1c of p-type semiconductor 1, and thereafter fired in a near-infrared radiation furnace. Thereby, back surface electrode 13 and highly-doped p-type layer 15 were simultaneously formed, as shown in Fig. 9. Here, back surface electrode 13 was formed to avoid a region with a diameter of approximately 5 mm about through-hole 19.

Subsequently, the first electrode 2 and the second electrode 7 were printed on the second main surface 1c of p-type semiconductor 1 using the screen printing method, and thereafter dried. Thereby, through-hole electrode portion 9 was formed inside through-hole 19, as shown in Fig. 9. Further, the first electrode 2 and the second electrode 7 were formed with silver with a diameter of approximately 3 mm, as shown in Fig. 9, to allow pn junction isolation portion 21 to be provided between back surface electrode 13 and each of them.

Next, a silver paste containing silver powder, a glass frit, a resin, and an organic solvent was screen-printed on anti-reflection film 23 in a pattern of sub electrode 5b shown in Fig. 1(a) (length; 20 mm, width: 0.07 mm, pitch: 2 mm).

Further, the silver paste containing silver powder, a glass frit, a resin, and an organic solvent was screen-printed on anti-reflection film 23 in a pattern of the first main electrode 5a shown in Fig. 1(a) (length; 152 mm, width: 0.75 mm). Furthermore, the silver paste containing silver powder, a glass frit, a resin, and an organic solvent was screen-printed on anti-reflection film 23 in a pattern of the second main electrode 5c shown in Fig. 1(a). Here, the second main electrode 5c has a pattern such that through-hole electrode portion 9 was widened to a width of approximately 1.5 mm only at the region around through-hole 19, to be in contact with the second main electrode 5c.

Thereafter, a light-receiving surface electrode pattern screen-printed as described above was fired in the near-infrared radiation furnace at a temperature of approximately 650°C, to form the light-receiving surface electrode (the first main electrode 5a, sub electrode 5b, and the second main electrode 5c). On this occasion, the light-receiving surface electrode pattern screen-printed as described above penetrated anti-reflection film 23 by being fired through, and thus the light-receiving surface electrode (the first main electrode 5a, sub electrode 5b, and the second main electrode 5c) in contact with n-type semiconductor 3 was able to be formed.

Further, at a portion other than the concave portion (the first concave portion 26 and the second concave portion 27), the first main electrode 5a had a height of approximately 0.02 mm from the first main surface 1a of p-type semiconductor 1. In addition, when the second main electrode 5c is brought into contact with through-hole electrode portion 9, the first main electrode 5a with a width of 0.75 mm is brought into contact with concave portion 26 and concave portion 27. That is, a high positioning accuracy was not required. Further, sub electrode 5b had a height of approximately 0.015 mm.

Through the steps described above, a photoelectric conversion device of Example 1 was completed. The light-receiving surface electrode had an external appearance with 73 sub electrodes 5b and 4 first main electrodes 5a. In the manufacturing method described above, the order of the steps may be changed as long as the photoelectric conversion device of Example 1 can be formed.

Current-voltage characteristics of the photoelectric conversion device of Example 1 thus obtained were measured. The measurement was performed under artificial sunlight with an irradiation intensity of 100 mW/cm² (JIS standard light AM 1.5G), with current terminals and voltage terminals being connected to the first main electrode 5a and back surface electrode 13 of the photoelectric conversion device of Example 1, at four locations in each electrode. Table 1 shows results thereof.

### <Comparative Example 1>

A photoelectric conversion device was fabricated as in Example 1 except for forming the first main surface 1a of p-type semiconductor 1 to be flat without forming the concave portion (the first concave portion 26 and the second concave portion 27) in the first main surface 1a of p-type semiconductor 1, and forming only the first main electrode 5a with a width of 1.5 mm as the main electrode of the light-receiving surface electrode without forming the second main electrode 5c.

Current-voltage characteristics of the photoelectric conversion device of Comparative Example 1 thus fabricated were measured as in Example 1. Table 1 shows results thereof.

### <Comparative Example 2>

A photoelectric conversion device was fabricated as in Example 1 except for forming the first main surface 1a of p-type semiconductor 1 to be flat without forming the concave portion (the first concave portion 26 and the second concave portion 27) in the first main surface 1a of p-type semiconductor 1.

Current-voltage characteristics of the photoelectric conversion device of Comparative Example 2 thus fabricated were measured as in Example 1. Table 1 shows results thereof.

The photoelectric conversion device of Comparative Example 2 is different from the photoelectric conversion device of Example 1 in that the concave portion (the first concave portion 26 and the second concave portion 27) is not formed in the first main surface 1a of p-type semiconductor 1, and is different from the photoelectric conversion device of Comparative Example 1 in that the second main electrode 5c is formed.

In the photoelectric conversion device of Comparative Example 2, the first main electrode 5a and the second main electrode 5c had a height of approximately 0.02 mm from the first main surface 1a of p-type semiconductor 1.

**[Table 1]**

| | Short Circuit Current Density (Jsc) [mA/cm²] | Open Voltage (Voc) [mV] | Fill Factor (F.F.) | Photoelectric Conversion Efficiency (Eff) [%] |
|---|---|---|---|---|
| Example 1 | 34.4 | 607 | 0.768 | 16.0 |
| Comparative Example 1 | 33.2 | 606 | 0.766 | 15.4 |
| Comparative Example 2 | 34.2 | 606 | 0.698 | 14.4 |

As shown in Table 1, it was confirmed that, concerning the characteristics such as photoelectric conversion efficiency (Eff), the photoelectric conversion device of Example 1 exhibited the best values.

This is attributed to the fact that, in the photoelectric conversion device of Example 1, short circuit current density (Jsc) can be improved by reducing the line width of the main electrode (the first main electrode 5a) of the light-receiving surface electrode, and the cross sectional area of the main electrode is increased by being formed in the concave portion (the first concave portion 26 and the second concave portion 27), causing no decrease in the fill factor (F.F.) value.

In the photoelectric conversion device of Comparative Example 1, it is considered that, although a high F.F. value was obtained as the main electrode of the light-receiving surface electrode had a wide line width, short circuit current density (Jsc) was decreased due to a decrease in the area of the light-receiving surface that absorbs light.

In the photoelectric conversion device of Comparative Example 2, it is considered that, although short circuit current density (Jsc) was able to be improved by reducing the line width of the main electrode of the light-receiving surface electrode, the F.F. value was decreased due to an increase in the line resistance of the main electrode of the light-receiving surface electrode.

It should be understood that the embodiments and examples disclosed herein are illustrative and non-restrictive in every respect. The scope of the present invention is defined by the scope of the claims, rather than the description above, and is intended to include any modifications within the scope and meaning equivalent to the scope of the claims.

### INDUSTRIAL APPLICABILITY

If the photoelectric conversion device of the present invention is used as a solar cell, a main electrode can be formed in a concave portion in a light-receiving surface of the solar cell in a fine structure and with a higher height. Therefore, a solar cell capable of maintaining an F.F. value at a high value and improving short circuit current density (Jsc) can be provided.

In particular, by applying the photoelectric conversion device of the present invention to a solar cell having an MWT (Metallization Wrap Through) cell structure described above, an increase in manufacturing cost can also be suppressed, since no additional manufacturing step is required.

## Claims

1. A photoelectric conversion device (10) including a first conductivity type semiconductor (1), and a through-hole (19) penetrating between a first main surface (1a) and a second main surface (1c) of said first conductivity type semiconductor (1), said first main surface (1a) of said first conductivity type semiconductor (1) being provided with a concave portion (26, 27) formed therein,
said photoelectric conversion device (10) comprising:
a second conductivity type semiconductor (3) formed in said first main surface (1a) of said first conductivity type semiconductor (1), an inner wall surface of said through-hole (19), and said second main surface (1c) of said first conductivity type semiconductor (1);
a light-receiving surface electrode (5a, 5c) formed to fill said concave portion (26, 27) in said first main surface (1a) of said first conductivity type semiconductor (1);
a first electrode (2) formed on said second main surface (1c) of said first conductivity type semiconductor (1);
a through-hole electrode portion (9) formed inside said through-hole (19) to be in contact with said second conductivity type semiconductor (3) in said inner wall surface of said through-hole (19); and
a second electrode (7) formed on said second conductivity type semiconductor (3) in said second main surface (1c) of said first conductivity type semiconductor (1) to be in contact with said through-hole electrode portion (9),
said light-receiving surface electrode (5a, 5c) and said second electrode (7) being electrically connected by said through-hole electrode portion (9).

2. A method of manufacturing a photoelectric conversion device (10) as recited in claim 1, comprising the steps of:
providing a conductive paste to fill said concave portion (26, 27); and
forming at least a portion of said light-receiving surface electrode (5a, 5c) by firing said conductive paste provided to said concave portion (26, 27).
